# EUROPEAN PATENT APPLICATION

(11) **EP 3 235 915 A1**
(43) Date of publication of application: **25.10.2017**
(21) Application number: 15845394.4
(22) Date of filing: 22.09.2015
(51) Int. Cl.: C22C 1/00, H01L 35/00, C01G 51/02, C01G 30/00, B82Y 30/00

(54) **METHOD FOR THE PRODUCTION OF NANOSTRUCTURED SKUTTERUDITES OF THE COSB3 TYPE**

(30) Priority: 23.09.2014 ES 201431385
(71) Applicant: Acondicionamiento Tarrasense (Centro Tecnológico LEITAT), 08225 Terrassa (ES); Consejo Superior De Investigaciones Científicas, 28006 Madrid (ES)
(72) Inventor: MARTÍNEZ CRESPIERA, Sandra, 08270 Navarcles (ES); AMANTIA, David, 08026 Barcelona (ES); PELEGRÍN RELLÁN, César, 08020 Barcelona (ES); MARTÍN GONZÁLEZ, María Soledad, 28055 Madrid (ES); RULL BRAVO, Marta, 28047 Madrid (ES); ABAD MAYOR, Begoña, 28029 Madrid (ES); FERNÁNDEZ LOZANO, José Francisco, 28770 Colmenar Viejo (ES); GUTIÉRREZ TAUSTE, David, 08500 Vic (ES); DELLA PIRRIERA, Monica, 08027 Barcelona (ES); FACCINI, Mirko, 08009 Barcelona (ES); AUBOUY, Laurent, 08290 Cerdanyola Del Vallès (ES)
(74) Representative: Oficina Ponti, SLP
(86) International application number: PCT/ES2015/070686
(87) International publication number: WO 2016/046437

(57) **Abstract**

The invention relates to a method for the production of nanostructured skutterudites of the CoSb₃ type from a solution of the corresponding precursor acetate salts and a polymer. The method includes a step of atomisation or electrospinning in order to eliminate the solvent from said solution and to nanostructure the precursor that is subsequently heat-treated under an inert atmosphere.

## Description

### Technical field

The present invention relates to the preparation of thermoelectric materials; more specifically, a method for the production of nanostructured skutterudites of the CoSb₃ type.

### Prior art

Thermoelectric materials are those capable of converting heat energy into electrical energy as a result of the Seebeck effect or, conversely, obtain a refrigeration effect from electrical energy, due to the Peltier effect.

Thermoelectric conversion technology has numerous applications, since it makes it possible to produce electricity from the residual heat released in various processes that would otherwise be wasted, which allows for greater energy efficiency and represents an energy source of great interest from the environmental standpoint.

Possible applications of thermoelectric materials are, for example, in the automotive industry, where the heat released by automobiles, particularly from the exhaust pipes, may be utilised, and in industrial facilities, where useful electrical energy may be generated from the heat released in various processes.

On the other hand, the refrigeration capacity of thermoelectric devices also has well-known applications, for example, in refrigeration systems, with the advantages that movable parts or potentially harmful refrigerating substances, such as freon gases, are not required, and that such systems have a very small size and weight.

The thermoelectric properties of materials are typically characterised by a parameter called figure of merit (Z) or a related parameter, called dimensionless figure of merit (ZT), which is defined by the formula ZT=S²α/κT, where S is a constant, called Seebeck coefficient, α is the electrical conductivity of the material, κ is its thermal conductivity and T is the absolute temperature.

In general, a good thermoelectric material has a high ZT value, for which reason it is desirable that said materials have a high electrical conductivity (α), but a low thermal conductivity (κ).

Worth highlighting amongst the main thermoelectric materials are skutterudites. The general formula for binary skutterudites is MX₃, where the metal atom M is generally Co, Ir or Rh, and X is a pnictogenic atom, which may be P, As or Sb. Binary skutterudites crystallise in a cubic structure with eight MX₃ groups in the unit cell, and the crystal structure presents two interstitial void spaces in each unit cell. For this reason, the formula for skutterudites is occasionally represented as V₂M₈X₂₄ or, alternatively, as VM₄X₁₂, where V represents the void spaces in the structure.

Amongst skutterudites, those based on CoSb₃ are of special interest as thermoelectric materials due to their excellent electrical conductivity properties and their high Seebeck coefficient. However, they have a high thermal conductivity. In order to reduce this high thermal conductivity, derivatives have been prepared by means of doping and/or the introduction of a filler element (rattling) into the voids of the crystal structure; said derivatives present even better thermoelectric properties, as a considerable reduction in their thermal conductivity is achieved whilst maintaining their good electrical conductivity.

Doped skutterudites are those wherein the M and/or X atoms are partially substituted by other elements. For example, doped skutterudites of the CoSb₃ type have been prepared by partially substituting the Co by transition metals, such as Fe or Ni, to form skutterudites of the Co₁₋ₓFeₓSb₃ or Co₁₋ₓNiₓSb₃ types, where the doping level may generally be of up to approximately 40%, i.e. x usually has a value ranging between 0 and approximately 0.4.

Skutterudites have also been prepared using a filler element; i.e. a host element is housed in some of the void spaces of the crystal structure, according to an R_{y}M₄X₁₂ structure, where R represents the filler element(s) and "*y*" is the filling fraction. Theoretically, the maximum filling fraction would be 1, i.e. with all the void spaces of the skutterudite occupied by a host element. However, in practice, the maximum effective filling fraction is typically lower, since it largely depends on each particular skutterudite and the nature of the filler elements introduced, as well as the possible doping elements.

In the case of skutterudites of the CoSb₃ type, said formula may be represented as R_{y}Co₄Sb₁₂. In general, said filler elements belong to the group of rare earths, such as lanthanides and actinides (La, Ce, Yb, Nd, Eu, Sm, Pm and Pr, for example), p-block metals or post-transition metals, such as TI or In, and also alkaline earth metals such as Ca, Sr or Ba.

Another well-known strategy to reduce the high thermal conductivity of skutterudites and thus improve their thermoelectric properties is by means of nanostructuring, as described in the literature, for example in the article Toprak et al. The impact of nanostructuring on the thermal conductivity of thermoelectric CoSb3. Adv. Funct. Mater., 2004, 14 (12), pp. 1189-1196.

Crushing techniques, such as grinding or milling, or those known as wet-chemistry techniques have been used to obtain nanostructured skutterudites. According to the literature, the best results have been obtained by means of ball-milling, melt-spinning and coprecipitation processes, as described, for example, in Lan et al. Enhancement of thermoelectric figure-of-merit by a bulk nanostructuring approach. Adv. Funct. Mater., 2010, 20, pp. 357-376.

In the prior art, numerous derivatives of skutterudites of the CoSb₃ type have been disclosed which present good properties as thermoelectric materials, undoped or doped with one or more elements, without filler elements or with one or more elements that partially fill the voids in the structure, and nanostructured or not.

Due to the multiple applications of thermoelectric materials, there is an increasing interest in the production of said materials and, consequently, in the development of new processes that allow for the preparation thereof in the most efficient and economical manner possible.

In the prior art, different methods for preparing thermoelectric materials of the skutterudite type have been disclosed.

The conventional method for synthesising skutterudite is based on the widely used metallurgical pathway wherein the elements are induction-melted at high temperatures and, subsequently, an annealing is performed, also at high temperature, for two weeks, for example as described in the article Kim et al. An optimization of composition ratio among triple-filled atoms in In0.3-x-yBaxCeyCo4Sb12 system. J. Nanomaterials, 2013, Article ID 973060.

Other methods have been disclosed in the literature for preparing nanostructured skutterudites. Thus, for example, a solid-phase preparation of different skutterudites of the CoSb₃ type has been disclosed which starts from its elementary components in the form of fine powder, using the grinding and hot pressing method, for example as described in the articles He et al. Nanostructured thermoelectric skutterudite Co1-xNixSb3 Alloys. J. Nanosci. Nanotechnol., 2008, 8, 40003-4006; or in Ur et al. Thermoelectric properties of nano-structured CoSb3 synthetized by mechanical alloying, Materials Science Forum, 2007, 534-537 (Pt. 2), 1425-1428.

Skutterudites of the CoSb₃ type have also been prepared from the corresponding precursors in the form of salts, to which end various reducing agents must be used in order to reduce the Co and the Sb from their oxidised forms Co²⁺ and Sb³⁺ present in said salts, until the skutterudite is formed.

Thus, for example, the article Yang et al. Synthesis of nano-sized CoSb3-based skutterudites using a modified polyol process. Thermoelectrics 2007, ICT 2007. 26th International Conference on Thermoelectrics, pp. 187-188, discloses the preparation of the CoSb₃ skutterudite using the process called modified polyol process, from the corresponding precursors in the form of a chloride salt, CoCl₂.6H₂0 and SbCl₃, in a solution with tetraethylene glycol as the solvent and using NaBH₄ as the reducing agent, and heating said solution to 240ºC. The powder product obtained must be washed and filtered several times with ethanol and distilled water, and subsequently dried.

The article Chu et al. Synthesis and thermal properties of nanoscale skutterudite via cross-precipitation. Key Engineering Materials, 2007, 336-338 (Pt. 1), pp. 831-833, discloses the preparation of CoSb₃ from a precursor obtained from the reaction of the chloride salts CoCl₂ and SbCl₃ with the precipitating agents sodium hydroxide and ammonia. The precursor thus obtained is reduced by means of a thermal treatment in a reducing atmosphere of hydrogen gas.

Despite the numerous processes disclosed in the prior art, there is still a need to develop an alternative method for preparing nanostructured skutterudites of the CoSb₃ type that is simple and economical, makes it possible to obtain a high-purity product from affordable starting products, with the least possible number of steps, and does not require delicate processes such as reduction in a hydrogen atmosphere.

### Object of the invention

The object of the present invention is a method for the production skutterudites of the CoSb₃ type.

### Description of the figures

Figure 1-A shows a photograph (image on the left) and two images taken with a scanning electronic microscope (images at the centre and on the right) of the intermediate nanostructured product obtained in Example 1, following spray drying and prior to the thermal treatment.
Figure 1-B shows a photograph (image on the left) and two images taken with a scanning electronic microscope (images at the centre and on the right) of the nanostructured skutterudite with the formula CoSb₃ obtained in Example 1, after performing the thermal treatment.
Figure 1-C shows the X-ray diffractogram of the nanostructured CoSb₃ skutterudite obtained in Example 1, where the x-axis represents the angle 2Theta and the y-axis represents the intensity. Said diffractogram substantially coincides with the reference diffractograms of CoSb₃ skutterudites available in the literature.
Figure 2-A shows the X-ray diffractogram of the nanostructured doped skutterudite with the formula Ni_{0.15}Co_{0.85}Sb₃ prepared in Example 2, where the x-axis represents the angle 2Theta and the y-axis represents the intensity.
Figure 2-B shows an image of said doped skutterudite obtained with a scanning electronic microscope.
Figure 3 shows the X-ray diffractogram of the doped skutterudite with the formula Fe_{0.2}Co_{0.8}Sb₃ prepared in Example 3, where the x-axis represents the angle 2Theta and the y-axis represents the intensity.
Figure 4 shows the X-ray diffractogram of the skutterudite with the formula Yb_{0.002}Ba_{0.08}La_{0.05}Co₄Sb₁₂ prepared in Example 4, where the x-axis represents the angle 2Theta and the y-axis represents the intensity.
Figure 5 shows the X-ray diffractogram of the skutterudite with the formula Ba_{0.3}Ni_{0.05}Co_{3.95}Sb₁₂ prepared in Example 5, where the x-axis represents the angle 2Theta and the y-axis represents the intensity.
Figure 6-A shows an image of the intermediate nanostructured product obtained in Example 6, following the electrospinning process, obtained with a scanning electronic microscope.
Figure 6-B shows an image taken with a scanning electronic microscope of the skutterudite with the formula CoSb₃ obtained in Example 6, following the corresponding thermal treatment of the intermediate of Figure 6-A.
Figure 6-C shows the X-ray diffraction pattern of the skutterudite with the formula CoSb₃ obtained in Example 6, where the x-axis represents the angle 2Theta and the y-axis represents the intensity. Said diffractogram substantially coincides with the reference diffractograms of CoSb₃ skutterudites available in the literature.
Figure 7-A shows a photograph of the intermediate product of Example 7, obtained following the electrospinning process (image on the left) and an image of said product obtained with a scanning electronic microscope (image on the right).
Figure 7-B shows a photograph of the nanostructured skutterudite with the formula CoSb₃ obtained in Example 7 (image on the left), following the corresponding thermal treatment of the intermediate of Figure 6-A, and an image of said skutterudite obtained with a scanning electronic microscope (image on the right)

### Detailed description of the invention

The object of the present invention is a method for the production skutterudites of the CoSb₃ type, selected from the compound with the general formula (I):

Co₁₋ₓDₓSb₃ (I)

wherein:
D is Ni or Fe, and
*x* ranges between 0 and 0.4,
and the compound with the general formula (II):

R_{y}Co_{4-x'}D_{x'}Sb₁₂ (II)

wherein:
D is Ni or Fe,
*x'* ranges between 0 and 1.6,
*y* is greater than 0 and less than or equal to 0.75, and
R represents one, two, three or four different elements selected from the group consisting of La, Ce, Yb, Nd, Eu, Pr, Sm, TI, In and Ba,
which comprises the following steps:
1) dissolving the acetate salts of each of their component elements and a polymer selected from polyvinylpyrrolidone and polyacrylonitrile in dimethylformamide;
2) eliminating the dimethylformamide from the solution prepared in step 1) by means of atomisation or electrospinning; and
3) thermally treating the product obtained in step 2) at a temperature ranging between 500ºC and 850ºC in an inert gas atmosphere.

The authors of the present invention have developed a method for the production of nanostructured skutterudites of the CoSb₃ type from the precursor acetate salts, which, surprisingly, makes it possible to obtain said thermoelectric material with a high purity by means of a thermal treatment that does not require using additional reducing agents. Moreover, when the nanostructured skutterudites are obtained, they present improved thermoelectric properties, with a high figure of merit (ZT).

### Skutterudites of the CoSb₃ type

Skutterudites are well-known within the field of thermoelectric materials, as described, for example, in the chapter Uher C. Structure-Property Relations in Skutterudites, pp. 121-146, in: Chemistry, Physics, and Materials Science of Thermoelectric Materials. Beyond Bismuth Telluride, edited by Kanatzidis, Mahanti and Hogan, Kluwer Academic, Plenum Publishers, New York, 2003 (ISBN 0-306-47738-6); or in the chapter Nolas et al. Semiconductors and Thermoelectric Materials, pp. 129-137, in: Thermal Conductivity. Theory, Properties, and Applications, edited by T. M. Tritt, Kluwer Academic, Plenum Publishers, New York, 2004 (ISBN 0-306-48327-0).

The chemical formula for binary skutterudites is MX₃, wherein the metal atom M is Co, Ir or Rh, and the X atom is P, As or Sb. The X atom is also called pnictogenic atom, since this is how the elements in Group V of the Periodic Table are occasionally called.

Skutterudites crystallise in a cubic structure, the unit cell thereof is composed of eight cubic spaces delimited by the metal atoms, with the interior occupied by four pnictogenic atoms that form a square ring, except for two of the eight cubic spaces, which are void. For this reason, the formula for skutterudites is occasionally represented as V₂M₈X₂₄ or, alternatively, as VM₄X₁₂, wherein V represents the void spaces in the structure.

Various skutterudites derivatives are also well-known, for example, doped skutterudites wherein the metal M is partially substituted by other metals, primarily Ni or Fe, and/or the pnictogenic atom is partially substituted by other atoms, for example, Sn or Te.

Also well-known are skutterudite derivatives wherein the void spaces in the crystal structure are partially filled with other elements, typically elements from the group of rare earths, such as lanthanides and actinides (La, Ce, Yb, Nd, Eu, Sm, Pm, and Pr, for example) or p-block elements or post-transition metals, such as TI or In, or elements from the alkaline earth metal group, such as Ca, Sr or Ba.

The present invention specifically relates to a method for the production skutterudites wherein the metal M is cobalt (Co) and the pnictogenic atom X is antimony (Sb), according to the formula CoSb₃, which are called "skutterudites of the CoSb₃ type".

As understood in the present invention, the term "skutterudites of the CoSb₃ type" broadly includes the following skutterudites based on the CoSb₃ skutterudite:
- forms with interstitial void spaces (unfilled),
- partially filled forms (called "rattled"), with up to four filler elements selected from La, Ce, Yb, Nd, Eu, Pr, Sm, TI, In and Ba, preferably selected from La, Ce, Yb and Ba, and, more preferably, with up to three filler elements selected from La, Yb and Ba;
whilst said skutterudites may be doped with the metals Ni or Fe partially substituting the Co.

Unfilled skutterudites of the CoSb₃ type, optionally doped with Ni or Fe, have the general formula Co₁₋ₓDₓSb₃ (I), wherein D is Ni or Fe, and *x* ranges between 0 and 0.4 (i.e. 0 ≤ *x* ≤ 0.4), and preferably between 0 and 0.25 (i.e. 0 ≤ *x* ≤ 0.25). When *x* = 0, it is a simple, undoped binary skutterudite with the formula CoSb₃. *x* values greater than 0, within the interval 0 < *x* ≤ 0.4 refer to forms doped with Ni or Fe.

Partially-filled skutterudites of the CoSb₃ type, optionally doped with Ni or Fe, are those which have the interstitial spaces partially occupied by a host element and the general formula R_{y}Co_{4-x'}D_{x'}Sb₁₂ (II), wherein D is Ni or Fe, and *x'* ranges between 0 and 1.6 (i.e. 0 ≤ *x'* ≤ 1.6), and preferably between 0 and 1 (i.e. 0 ≤ *x'* ≤ 1), such that, when *x'* = 0, they are undoped forms and, for *x'* values greater than 0, within the interval 0 < *x'* ≤ 1.6, or the preferred sub-interval 0 < *x'* ≤ 1, they are forms doped with Ni or Fe. The parameter "*y*" represents the filling level, with values within the range 0 < *y* ≤ 0.75, preferably within the range 0 < *y* ≤ 0.5 and, more preferably, within the range 0 < *y* ≤ 0.3; and R represents one, two, three or four filler elements selected from the group consisting of La, Ce, Yb, Nd, Eu, Pr, Sm, TI, In and Ba, and preferably from La, Ce, Yb and Ba; and, more preferably, R represents one, two or three filler elements selected from the group consisting of La, Yb and Ba.

In the formula (II), R represents between one and four different filler elements, i.e. the filled forms also include forms with more than one host or filler element R, generally up to four different filler elements, such that the formula (II) R_{y}Co_{4-x'}D_{x'}Sb₁₂ is implicitly understood to include those forms wherein R represents one, two, three or four filler elements, and, in turn, the parameter *y* implicitly represents each of the partial filling levels.

In other words, the general formula (II) R_{y}Co_{4-x'}D_{x'}Sb₁₂ is understood to include the formulas R¹_{y1}Co_{4-x'}D_{x'}Sb₁₂ (IIa), with a single filler element R¹, R¹_{y1}R²_{y2}Co_{4-x'}D_{x'}Sb₁₂ (IIb), with two different filler elements (R¹ and R²), R¹_{y1}R²_{y2}R³_{y3}Co_{4-x'}D_{x'}Sb₁₂ (IIc), with three different filler elements (R¹, R² and R³), and R¹_{y1}R²_{y2}R³_{y3}R⁴_{y4}Co_{4-x'}DₓSb₁₂ (IId), with four different filler elements (R¹, R², R³ and R⁴), wherein R¹, R², R³ and R⁴ may be La, Ce, Yb, Nd, Eu, Pr, Sm, TI, In or Ba, and preferably, are selected from La, Ce, Yb and Ba; wherein *y*₁, *y*₂, *y*₃ and *y*₄ represent the partial filling levels for each element R¹, R², R³ and R⁴, respectively, such that the sum is *y*, i.e. *y*₁ + *y*₂ + *y*₃ + *y*₁ = *y*, and wherein *x'* and D have the same meaning described above for the formula (II).

In a particularly preferred embodiment, R represents between one and three different filler elements that are selected from La, Yb and Ba. I.e. in this case the general formula (II) includes the formulas (IIa), with a single filler element R¹, (IIb), with two different filler elements (R¹ and R²), and (IIc), with three different filler elements (R¹, R² and R³), as defined above, wherein R¹, R² and R³ are selected from La, Yb and Ba.

### Preparation of a solution with the skutterudite precursors and a polymer

The first step of the method of the present invention consists of dissolving the acetate salts of each of the component elements of skutterudite, together with a polymer selected from polyvinylpyrrolidone (PVP) and polyacrylonitrile (PAN), in dimethylformamide (DMF).

The skutterudite according to the method of the present invention is prepared from the precursors thereof, which are the acetate salts of each of their component elements, i.e. cobalt acetate and antimony acetate, and, optionally, the acetate salts of nickel, iron, lanthanum, cerium, ytterbium, neodymium, europium, praseodynium, samarium, thallium, indium or barium, in order to prepare the corresponding skutterudites doped with nickel (Ni) or iron (Fe), and/or filled with lanthanum (La), cerium (Ce), ytterbium (Yb), neodymium (Nd), europium (Eu), praseodynium (Pr), samarium (Sm), thallium (TI), indium (In), and/or barium (Ba) in the interstitial spaces, as described above.

The acetate salts of the component elements are well-known in the prior art, and are composed of the acetate anion (CH₃COO⁻) and the corresponding elements Co, Sb, Ni, Fe, La, Ce, Yb, Nd, Eu, Pr, Sm, TI, In or Ba in cationic form, according to their oxidation states.

Specifically, Co (II) acetate or Co (III) acetate are used; more preferably, the following are used: Co (II) acetate, Sb (III) acetate, iron (II) acetate, nickel (II) acetate, lanthanum (III) acetate, cerium (III) acetate, ytterbium (III) acetate, neodymium (III) acetate, europium (III) acetate, praseodynium (III) acetate, samarium (III) acetate, thallium (III) acetate, indium (III) acetate and barium (II) acetate.

Within the context of the invention, the acetate salts also include the possible hydrated forms thereof.

The precursor acetate salts may be prepared by means described in the prior art, and are also commercially available, for example, through the companies Sigma-Aldrich or Alfa Aesar.

The solution prepared in step 1) contains the precursor acetate salts and a polymer selected from polyvinylpyrrolidone (PVP) and polyacrylonitrile (PAN). Preferably, PVP is used.

Polyvinylpyrrolidone, also known as povidone or PVP, is the 1-ethenyl-2-pyrrolidone homopolymer. Polyvinylpyrrolidone exists in different degrees, depending on the molecular weight. In the method of the present invention, in any of the embodiments that comprise using PVP, PVP with a mean molecular weight ranging between 5,000 g/mol and 2,000,000 g/mol is preferably used, more preferably ranging between 100,000 g/mol and 1,500,000 g/mol, even more preferably ranging between 1,000,000 g/mol and 1,400,000 g/mol, and, even more preferably, with a mean molecular weight of 1,300,000 g/mol, such as, for example, that distributed by the company Sigma-Aldrich.

Polyacrylonitrile, also known by the acronym PAN, is the acrylonitrile homopolymer. In the method of the present invention, in any of the embodiments that comprise using PAN, polyacrylonitrile with a mean molecular weight ranging between 100,000 g/mol and 200,000 g/mol is preferably used, and preferably PAN with a mean molecular weight of 150,000 g/mol, such as, for example, that distributed by the company Sigma-Aldrich.

The solvent used in this first step is dimethylformamide, also called *N*,*N-*dimethylformamide or DMF, which is a good solvent for both the precursor acetate salts and the PVP and PAN polymers.

The molar ratio between the Co acetate and the Sb acetate used to prepare the solution of step 1) of the method according to the invention typically ranges between (1 - *x*):3 and (1 - *x*):4.5, to prepare unfilled skutterudites with the formula (I), or between (1 - *x'*/4):3 and (1 - *x'*/4):4.5, to prepare filled skutterudites with the formula (II), wherein *x* and *x'* have the same meaning described above for the formulas (I) and (II).

Therefore, according to this molar ratio, when undoped skutterudites with the formula (I) (*x* = 0) or the formula (II) (*x'*= 0) are prepared, the molar ratio between Co acetate and Sb acetate used to prepare the solution of step 1) typically ranges between 1:3 and 1:4.5.

The concentration of the precursor acetate salts in the DMF solution of step 1) generally ranges between 5% and 20% by weight, with respect to the weight of the solution.

Throughout the present invention, we refer to the concentration of the solution of step 1) as the weight percentages of each component, i.e. the ratio between the weight of said component with respect to the total weight of the solution, the latter including the weight of dimethylformamide and that of all the components, i.e. the salts and the polymer.

When reference is made to the concentration, or weight percentage, of the precursor acetate salts, reference is made to the sum of the weights of all the acetate salts present in the solution with respect to the total weight of the solution.

The concentration of the polymer in the DMF solution of step 1) generally ranges between 5% and 15% by weight.

Preferably, the weight ratio of polymer:precursor acetate salts in the solution prepared in step 1) ranges between 2.1:1 and 1:1.1, more preferably the ratio is approximately 1:1 by weight and, even more preferably, it is 1:1.

Throughout the present description, when reference is made to the weight ratios of polymer:precursor acetate salts, the weight of the precursor acetate salts corresponds to the sum of all the salts used.

When a hydrated acetate salt is used, the total weight of the salt is taken into consideration, including the hydration water.

### Elimination of the solvent by means of a atomisation process

The second step of the method according to the present invention consists of eliminating the solvent, i.e. the dimethylformamide, from the solution prepared in step 1), to obtain an intermediate nanostructured product.

In one embodiment of the invention, the elimination of the solvent is performed by means of a atomisation process, also known as spray-drying.

The atomisation process, or spray-drying, is a well-known method used to produce particles of a given material from a solution or suspension by means of rapid drying with hot gas. The atomisation process has numerous industrial applications, since it makes it possible to prepare pulverulent products with various compositions. The size of the particles obtained for a given product may vary depending on the concentration of the initial solution or suspension, the temperature used in the drying process, and the flow rate at which the solution is introduced into the atomiser.

The DMF solution prepared in step 1), which contains the precursor acetate salts of skutterudite and the polymer, is subjected to a atomisation process by means of which the dimethylformamide is eliminated, to leave a solid residue, typically in the form of microparticles and nanofibres.

Any conventional equipment may be used to perform said process, such as any commercially accessible one, for example, the Mini Spray Dryer B-290 equipment from the company Buchi.

A temperature ranging between room temperature and 220ºC may be used, preferably ranging between 160ºC and 180ºC, and, more preferably, 170ºC.

The feed flow rate typically ranges between 4 ml/min and 8 ml/min, and, preferably, is 6 ml/min.

It is understood that said conditions are for guidance only, and that a person skilled in the art knows how to adjust said parameters on the basis of the desired characteristics of the atomised product.

The concentration of the polymer in the initial solution prepared in step 1) that is subjected to the spray drying process preferably ranges between 5% and 10%, more preferably between 6% and 9%, and, even more preferably, between 7.5% and 8.5%, wherein said percentages are expressed by weight, i.e. as the weight of the polymer with respect to the total weight of the solution. In a particularly preferred embodiment, the polymer is PVP.

The concentration of the precursor acetate salts in the initial solution prepared in step 1) that is subjected to the spray drying process preferably ranges between 5% and 10%, more preferably between 6% and 9%, and, even more preferably, between 7.5% and 8.5%, wherein said percentages are expressed by weight, i.e. as the sum of the weight of the precursor acetate salts with respect to the total weight of the solution.

When the method of the invention comprises a spray drying process in step 2), the weight ratio of polymer:precursor acetate salts in the solution prepared in step 1) preferably ranges between 1.1:1 and 1:1.1, more preferably, the ratio is approximately 1:1 by weight, and, even more preferably, the ratio is 1:1. When referring to this ratio, it is understood that the weight of the precursor acetate salts corresponds to the sum of all the salts used.

When the method of the invention comprises a spray drying process in step 2), the proportion between the precursor acetate salts used to prepare the solution of step 1) is preferably a stoichiometric molar ratio.

Therefore, in order to prepare an unfilled skutterudite of the CoSb₃ type, optionally doped with Ni or Fe, with the formula (I) Co₁₋ₓDₓSb₃, wherein D is Ni or Fe, and *x* has a value ranging between 0 and 0.4 (i.e. 0 ≤ *x* ≤ 0.4), and preferably ranging between 0 and 0.25 (i.e. 0 ≤ *x* ≤ 0.25), a molar ratio of cobalt acetate:antimony acetate:iron acetate or nickel acetate (1 - x):3:x is preferably used.

Specifically, in order to prepare a simple skutterudite of the CoSb₃ type, unfilled and undoped, with the formula CoSb₃ (formula (I) for *x*= 0), a molar ratio of cobalt acetate:antimony acetate of 1:3 is preferably used.

Similarly, in order to prepare a nanostructured skutterudite of the CoSb₃ type filled with at least one element selected from La, Ce, Yb, Nd, Eu, Pr, Sm, TI, In and Ba, preferably selected from La, Ce, Yb and Ba, and, even more preferably, filled with a maximum of three elements selected from La, Yb and Ba, and optionally doped with Ni or Fe, with the general formula (II) R_{y}Co_{4-x'}D_{x'}Sb₁₂, wherein R represents the filler element(s), D is Ni or Fe, and *x*' ranges between 0 and 1.6, and, more preferably, between 0 and 1, and *y* has a value within the range 0 < *y* ≤ 0.75, more preferably within the range 0 < *y* ≤ 0.5, and, even more preferably, within the range 0 < *y* ≤ 0.3, a molar ratio of the acetate of the filler element(s) R:iron or nickel acetate:cobalt acetate:antimony acetate of *y:x':*(*4 - x*):12 is preferably used. In this ratio, *y* represents the set of the partial filling levels for each of the filler elements, and it is understood that, when there is more than one filler element (R¹, R², etc.), the ratio is stoichiometric with respect to each of the precursor acetate salts. Thus, when there is only one filler element R¹, with a filling level *y*₁, a molar ratio between the precursor acetate salts of *y*₁*:x'*:(4 - *x'*):12 is preferably used; when there are two different filler elements R¹ and R², with partial filling levels of *y*₁ and *y*₂, respectively, a molar ratio between the precursor acetate salts of *y*₁:y₂:*x'*:(4 - *x'*):12 is preferably used; when there are three different filler elements R¹, R² and R³, with partial filling levels of *y*₁, *y₂* and *y*₃, respectively, a molar ratio between the precursor acetate salts of *y₁:y₂:y₃:x'*:(4 - *x'*):12 is preferably used; and, when there are four different filler elements R¹, R², R³ and R⁴, with partial filling levels of *y₁*, *y₂*, *y₃* and *y₄*, respectively, a molar ratio between the precursor acetate salts of *y*₁:*y₂:y₃:y₄:x':*(4 - *x'*):12 is preferably used.

It is understood that the preferred stoichiometric ratio between the precursor acetate salts used also includes small variations of up to 5%, which are also considered to be included within the term "stoichiometric ratio".

### Elimination of the solvent by means of an electrospinning process

According to one embodiment of the invention, the elimination of the solvent in the second step of the method is performed by means of an electrospinning process.

The electrospinning process is also well-known in the prior art, and it makes it possible to prepare nanofibres from a solution of a given material, typically polymers, by applying an electric current with a sufficiently high voltage, which causes the expulsion of fine threads from a capillary tube, whilst the solvent is evaporated, thereby forming nanofibres of said material.

Thus, the DMF solution prepared in step 1), which contains the precursor acetate salts of skutterudite and the polymer, is subjected to an electrospinning process by means of which the dimethylformamide is eliminated, and nanofibres are formed that contain said polymer and the corresponding precursor acetate salts.

Suitable conditions to perform the electrospinning include, for example, a voltage of 30 kV, a flow rate ranging between 1 and 3 ml/h for one needle, or 7 ml/h for a multijet system, a distance between the needle and the collector of 15 cm, and a collection rate of 500 rpm.

Said conditions are understood to be for guidance only, and a person skilled in the art knows how to adjust said parameters on the basis of the desired characteristics of the product to be prepared.

The concentration of the polymer in the initial solution prepared in step 1) that is subjected to drying by electrospinning typically ranges between 4% and 16%.

In one preferred embodiment, the polymer is polyvinylpyrrolidone and the concentration of said polymer in the initial solution prepared in step 1) preferably ranges between 8% and 14%, and, more preferably, between 12% and 13%, wherein said percentages are expressed by weight, i.e. as the weight of the polymer with respect to the total weight of the solution. In an even more preferred embodiment, a weight ratio of polyvinylpyrrolidone:precursor acetate salts in the solution of step 1) ranging between 1.1:1 and 1:1.1 is used, more preferably the ratio is approximately 1:1 by weight, and, even more preferably, the ratio is 1:1. When referring to this ratio, it is understood that the weight of the precursor acetate salts corresponds to the sum of all the salts used.

In another preferred embodiment, the polymer is polyacrylonitrile and the concentration of said polymer in the initial solution prepared in step 1) preferably ranges between 4% and 8%, wherein the percentage is expressed by weight, i.e. as the weight of the polymer with respect to the total weight of the solution. In an even more preferred embodiment, a weight ratio of polyacrylonitrile:precursor acetate salts in the solution of step 1) ranging between 1:2.1 and 1.1:2 is used, more preferably, the ratio is approximately 1:2 by weight, and, even more preferably, the ratio is 1:2. When referring to this ratio, it is understood that the weight of the precursor acetate salts corresponds to the sum of all the salts used.

The concentration of the precursor acetate salts in the initial solution prepared in step 1) that is subjected to drying by electrospinning preferably ranges between 8% and 16%, and, more preferably, between 10% and 15%, wherein said percentages are expressed by weight, i.e. as the sum of the weights of the precursor acetate salts with respect to the total weight of the solution.

In a particularly preferred embodiment of the invention, the molar ratio of cobalt acetate:antimony acetate in the initial solution that is subjected to electrospinning preferably ranges between (1 - *x*):4.25 and (1 - *x*):4.75, and, more preferably, it is (1 - *x*):4.5, to prepare unfilled skutterudites with the formula (I), or preferably ranges between (1 - *x'*/4):4.25 and (1 - *x*'/4):4.75, and, more preferably, it is (1 - *x'*/4):4.5, to prepare filled skutterudites with the formula (II), wherein *x* and *x'* have the same meaning described above for the formulas (I) and (II). Thus, in order to prepare undoped skutterudites (*x* = 0 or *x*'= 0), a molar ratio of cobalt acetate:antimony acetate ranging between 1:4.25 and 1:4.75 is preferably used, and, more preferably, said ratio is 1:4.5.

### Thermal treatment

According to step 3) of the method of the invention, the dry residue obtained following elimination of the solvent, either after atomisation or after electrospinning, is subjected to a thermal treatment at a temperature ranging between 500ºC and 850ºC in an inert gas atmosphere.

Said thermal treatment is typically performed in a suitable oven, such as those commercially available; for example, a CWF 1200 model oven, from the company Carbolite, may be used, equipped with a gas chamber from Inconel®.

As it is well-known to a person skilled in the art, the use of an inert gas atmosphere refers to the use of a gas that does not react, primarily in order to prevent undesired hydrolysis and oxidation reactions, to which purpose noble gases or nitrogen are typically used. The most habitual inert gases are argon and nitrogen. In the method of the present invention, argon gas is preferably used.

In one embodiment of the invention, when the method comprises a spray drying process in step 2), the subsequent thermal treatment of the atomised product according to step 3) of the method of the invention is preferably performed at a temperature ranging between 500ºC and 650ºC, more preferably ranging between 525ºC and 575ºC, and, even more preferably, at a temperature of 550ºC. In general, said thermal treatment is preferably performed for a period ranging between 5 and 7 hours, preferably for 6 hours.

In another embodiment of the invention, when the method comprises drying by electrospinning in step 2), the subsequent thermal treatment of the product resulting from the electrospinning process according to step 3) of the method of the invention is preferably performed at a temperature ranging between 700ºC and 850ºC, more preferably ranging between 775ºC and 825ºC, and, even more preferably, at a temperature of 800ºC. Said treatment is generally performed for a period ranging between 2 and 4 hours, preferably for 3 hours. Preferably, the polymer is PVP.

In another embodiment of the invention, when the method comprises drying by electrospinning in step 2), the subsequent thermal treatment of the product resulting from the electrospinning process according to step 3) of the method of the invention is preferably performed at a temperature ranging between 500ºC and 600ºC, more preferably ranging between 525ºC and 575ºC, and, even more preferably, at a temperature of 550ºC. Said treatment is generally performed for a period ranging between 10 and 18 hours, preferably for 16 hours. Preferably, the polymer is PAN.

According to a preferred embodiment of the present invention, the method for the production skutterudites of the CoSb₃ type with the formula (I) or with the formula (II), as defined above, comprises the following steps:
1) dissolving the acetate salts of each of their component elements and polyvinylpyrrolidone in dimethylformamide, wherein the solution preferably has a concentration of polyvinylpyrrolidone ranging between 5% and 10%, more preferably ranging between 6% and 9%, and, even more preferably, ranging between 7.5% and 8.5%; and a concentration of the precursor acetate salts ranging between 5% and 10%, more preferably ranging between 6% and 9%, and, even more preferably, ranging between 7.5% and 8.5%, wherein said percentages are expressed by weight;
2) eliminating the dimethylformamide from the solution prepared in step 1) by means of atomisation; and
3) thermally treating the product obtained in step 2) at a temperature ranging between 500ºC and 650ºC; preferably between 525ºC and 575ºC, and, even more preferably, at 550ºC, in an inert gas atmosphere for a period preferably ranging between 5 and 7 hours, and, more preferably for 6 hours;
wherein the weight ratio of polymer:precursor acetate salts in the solution of step 1) preferably ranges between 1.1:1 and 1:1.1;
wherein the precursor acetate salts are preferably used in a relative quantity according to a stoichiometric molar ratio; and
wherein a polyvinylpyrrolidone with a mean molecular weight ranging between 5,000 g/mol and 2,000,000 g/mol is preferably used, more preferably ranging between 100,000 g/mol and 1,500,000 g/mol, even more preferably ranging between 1,000,000 g/mol and 1,400,000 g/mol, and, even more preferably, with a mean molecular weight of 1,300,000 g/mol.

A preferred embodiment of the present invention relates to a method for the production a skutterudite with the formula CoSb₃ which comprises the following steps:
1) dissolving cobalt (II) acetate and antimony (III) acetate, in a 1:3 molar ratio, and polyvinylpyrrolidone in dimethylformamide, wherein the concentration of polyvinylpyrrolidone preferably ranges between 5% and 10%, more preferably between 6% and 9%, and, even more preferably, between 7.5% and 8.5%; and the concentration of the acetate salts ranges between 5% and 10%, more preferably between 6% and 9%, and, even more preferably, between 7.5% and 8.5%, wherein the percentages are expressed by weight;
2) eliminating the dimethylformamide from the solution prepared in step 1) by means of atomisation; and
3) thermally treating the product obtained in step 2) at a temperature ranging between 500ºC and 650ºC, preferably between 525ºC and 575ºC, and, more preferably, at 550ºC, in an inert gas atmosphere for a period preferably ranging between 5 and 7 hours, and, more preferably, for 6 hours;
wherein the weight ratio of polymer:precursor acetate salts in the solution prepared in step 1) preferably ranges between 1.1:1 and 1:1.1; and
wherein a polyvinylpyrrolidone with a mean molecular weight ranging between 5,000 g/mol and 2,000,000 g/mol is preferably used, more preferably ranging between 100,000 g/mol and 1,500,000 g/mol, even more preferably ranging between 1,000,000 g/mol and 1,400,000 g/mol, and, even more preferably, with a mean molecular weight of 1,300,000 g/mol.

Another preferred embodiment of the present invention relates to a method for the production a doped skutterudite with the formula (I) Co₁₋ₓDₓSb₃, wherein D is selected from Ni and Fe, and *x* has a value within the range 0 < *x* ≤ 0.4, and, more preferably, within the range 0 < *x* ≤ 0.25, which comprises the following steps:
1) dissolving cobalt (II) acetate, antimony (III) acetate and a salt selected from iron (II) acetate and nickel (II) acetate, in a (1 - *x*):3:*x* molar ratio, and polyvinylpyrrolidone in dimethylformamide; wherein the concentration of polyvinylpyrrolidone preferably ranges between 5% and 10%, more preferably between 6% and 9%, and, even more preferably, between 7.5% and 8.5%; and the concentration of the precursor acetate salts ranges between 5% and 10%, more preferably between 6% and 9%, and, even more preferably, between 7.5% and 8.5%, wherein the percentages are expressed by weight;
2) eliminating the dimethylformamide from the solution prepared in step 1) by means of atomisation; and
3) thermally treating the product obtained in step 2) at a temperature ranging between 500ºC and 650ºC, preferably between 525ºC and 575ºC, and, even more preferably, at 550ºC, in an inert gas atmosphere for a period preferably ranging between 5 and 7 hours, and, more preferably, for 6 hours;
wherein the weight ratio of polymer:precursor acetate salts in the solution prepared in step 1) preferably ranges between 1.1:1 and 1:1.1; and
wherein a polyvinylpyrrolidone with a mean molecular weight ranging between 5,000 g/mol and 2,000,000 g/mol is preferably used, more preferably ranging between 100,000 g/mol and 1,500,000 g/mol, even more preferably ranging between 1,000,000 g/mol and 1,400,000 g/mol, and, even more preferably, with a mean molecular weight of 1,300,000 g/mol.

In a particularly preferred embodiment of this embodiment, D is Ni and *x* is 0.15. In another particularly preferred embodiment of this embodiment, D is Fe and *x* is 0.2.

Another preferred embodiment of the present invention relates to a method for the production a filled skutterudite with the formula (II) R_{y}Co_{4-x'}D_{x'}Sb₁₂, wherein R represents one, two, three, or four different filler elements that are selected from La, Ce, Yb, Nd, Eu, Pr, Sm, TI, In and Ba, and, preferably, between La, Ce, Yb and Ba; and, more preferably, R represents one, two or three different filler elements that are selected from La, Yb and Ba; *y* has a value within the range 0 < *y* ≤ 0.75, preferably within the range 0 < *y* ≤ 0.5, and, more preferably, within the range 0 < *y* ≤ 0.3; D is selected from Ni and Fe; and *x'* has a value within the range 0 ≤ *x'* ≤ 1.6, and, preferably, within the range 0 ≤ *x'* ≤ 1, which comprises the following steps:
1) dissolving cobalt (II) acetate, antimony (III) acetate, optionally one salt selected from iron (II) acetate and nickel (II) acetate, and the acetate salt(s) of the filler element(s) R, in a (4 *- x'*):12:*x':y* molar ratio, and polyvinylpyrrolidone in dimethylformamide; wherein the concentration of polyvinylpyrrolidone preferably ranges between 5% and 10%, more preferably between 6% and 9%, and, even more preferably, between 7.5% and 8.5%; and the concentration of the precursor acetate salts ranges between 5% and 10%, more preferably between 6% and 9%, and, even more preferably, between 7.5% and 8.5%, wherein the percentages are expressed by weight;
2) eliminating the dimethylformamide from the solution prepared in step 1) by means of atomisation; and
3) thermally treating the product obtained in step 2) at a temperature ranging between 500ºC and 650ºC, preferably between 525ºC and 575ºC, and, even more preferably, at 550ºC, in an inert gas atmosphere for a period preferably ranging between 5 and 7 hours, and, more preferably, for 6 hours;
wherein the weight ratio of polymer:precursor acetate salts in the solution prepared in step 1) preferably ranges between 1.1:1 and 1:1.1; and
wherein a polyvinylpyrrolidone with a mean molecular weight ranging between 5,000 g/mol and 2,000,000 g/mol is preferably used, more preferably ranging between 100,000 g/mol and 1,500,000 g/mol, even more preferably ranging between 1,000,000 g/mol and 1,400,000 g/mol, and, even more preferably, with a mean molecular weight of 1,300,000 g/mol.

In a particularly preferred embodiment of the embodiment, the skutterudite with the formula (II) is Yb_{0.002}Ba_{0.08}La_{0.05}Co₄Sb₁₂, i.e. R represents the elements R¹, R² and R³, wherein R¹ is Yb, R² is Ba and R³ is La, *y₁* = 0.002, *y₂* = 0.08, *y₃* = 0.05, *y₁* + *y₂* + *y₃* = 0.132, and *x'* = 0. In another particularly preferred embodiment of this embodiment, the skutterudite with the formula (II) is Ba_{0.3}Ni_{0.05}Co_{3.95}Sb₁₂, i.e. R represents a single element R¹, which is Ba, *y* = *y₁* = 0.3, D is Ni and *x*'= 0.05.

According to a preferred embodiment of the present invention, the method for the production skutterudites of the CoSb₃ type with the formula (I) or the formula (II), as defined above, comprises the following steps:
1) dissolving the acetate salts of each of their component elements, wherein the molar ratio of cobalt acetate:antimony acetate ranges between (1 - *x*):4.25 and (1 - *x*):4.75, or between (1 - *x'*/4):4.25 and (1 - *x'*/4):4.75, and, more preferably, said ratio is (1 - *x*):4.5 or (1 - *x'*/4):4.5, and polyvinylpyrrolidone in dimethylformamide, wherein the concentration of polyvinylpyrrolidone preferably ranges between 8% and 15%, more preferably between 10% and 14%, and, even more preferably, between 12% and 13%; and the concentration of the precursor acetate salts ranges between 8% and 15%, more preferably between 10% and 14%, and, even more preferably, between 12% and 13%, wherein the percentages are expressed by weight;
2) eliminating the dimethylformamide from the solution prepared in step 1) by means of electrospinning; and
3) thermally treating the product obtained in step 2) at a temperature ranging between 700ºC and 850ºC, preferably between 775ºC and 825ºC, and, more preferably, at approximately 800ºC in an inert gas atmosphere for a period preferably ranging between 2 and 4 hours, and, more preferably, for approximately 3 hours;
wherein the weight ratio of polymer:precursor acetate salts in the solution prepared in step 1) preferably ranges between 1.1:1 and 1:1.1; and
wherein a polyvinylpyrrolidone with a mean molecular weight ranging between 5,000 g/mol and 2,000,000 g/mol is preferably used, more preferably ranging between 100,000 g/mol and 1,500,000 g/mol, even more preferably ranging between 1,000,000 g/mol and 1,400,000 g/mol, and, even more preferably, with a mean molecular weight de 1,300,000 g/mol.

A preferred embodiment of the present invention relates to a method for the production an unfilled undoped skutterudite with the formula CoSb₃, which comprises the following steps:
1) dissolving cobalt (II) acetate and antimony (III) acetate at a molar ratio ranging between 1:4.25 and 1:4.75, and, preferably, 1:4.5, and polyvinylpyrrolidone in dimethylformamide, wherein the concentration of polyvinylpyrrolidone preferably ranges between 8% and 15%, more preferably between 10% and 14%, and, even more preferably, between 12% and 13%; and the concentration of the precursor acetate salts ranges between 8% and 15%, more preferably between 10% and 14%, and, even more preferably, between 12% and 13%, wherein the percentages are expressed by weight;
2) eliminating the dimethylformamide from the solution prepared in step 1) by means of electrospinning; and
3) thermally treating the product obtained in step 2) at a temperature ranging between 700ºC and 850ºC, preferably ranging between 775ºC and 825ºC, and, more preferably, at approximately 800ºC in an inert gas atmosphere for a period preferably ranging between 2 and 4 hours, and, more preferably, for approximately 3 hours;
wherein the weight ratio of polymer:precursor acetate salts in the solution prepared in step 1) preferably ranges between 1.1:1 and 1:1.1; and
wherein a polyvinylpyrrolidone with a mean molecular weight ranging between 5,000 g/mol and 2,000,000 g/mol is preferably used, more preferably ranging between 100,000 g/mol and 1,500,000 g/mol, even more preferably ranging between 1,000,000 g/mol and 1,400,000 g/mol, and, even more preferably, with a mean molecular weight of 1,300,000 g/mol.

Another preferred embodiment of the present invention relates to a method for the production skutterudites of the CoSb₃ type with the formula (I) or the formula (II), as defined above, which comprises the following steps:
1) dissolving the acetate salts of each of their component elements, wherein the molar ratio of cobalt acetate:antimony acetate ranges between (1 - *x*):4.25 and (1 - *x*):4.75, or between (1 - *x'*/4):4.25 and (1 - *x'*/4):4.75, and, more preferably, said ratio is (1 - *x*):4.5 or (1 - *x'*/4):4.5, and polyacrylonitrile in dimethylformamide; wherein the concentration of polyacrylonitrile preferably ranges between 4% and 10%, and, more preferably, between 7% and 8%; and the concentration of the precursor acetate salts ranges between 8% and 20%, and, more preferably, between 14% and 16%, wherein the percentages are expressed by weight;
2) eliminating the dimethylformamide from the solution prepared in step 1) by means of electrospinning; and
3) thermally treating the product obtained in step 2) at a temperature ranging between 500ºC and 600ºC, preferably ranging between 525ºC and 575ºC, and, more preferably, at a temperature of approximately 550ºC in an inert gas atmosphere for a period preferably ranging between 10 and 18 hours, and, more preferably, for approximately 16 hours;
wherein the weight ratio of polymer:precursor acetate salts in the solution prepared in step 1) preferably ranges between 1.1:2 and 1:2.1, and, more preferably is approximately 1:2; and
wherein a polyacrylonitrile with a mean molecular weight ranging between 100,000 g/mol and 200,000 g/mol is preferably used, and, more preferably, a PAN with a mean molecular weight of approximately 150,000 g/mol is used.

Another preferred embodiment of the present invention relates to a method for the production an unfilled undoped skutterudite with the formula CoSb₃, which comprises the following steps:
1) dissolving cobalt (II) acetate and antimony (III) acetate at a molar ratio ranging between 1:4.25 and 1:4.75, and, more preferably, said ratio is 1:4.5, and polyacrylonitrile in dimethylformamide; wherein the concentration of polyacrylonitrile preferably ranges between 4% and 10%, and, more preferably, between 7% and 8%; and the concentration of the precursor acetate salts ranges between 8% and 20%, and, more preferably, between 14% and 16%, wherein the percentages are expressed by weight;
2) eliminating the dimethylformamide from the solution prepared in step 1) by means of electrospinning; and
3) thermally treating the product obtained in step 2) at a temperature ranging between 500ºC and 600ºC, preferably ranging between 525ºC and 575ºC, and, more preferably, at a temperature of approximately 550ºC in an inert gas atmosphere for a period preferably ranging between 10 and 18 hours, and, more preferably, for approximately 16 hours;
wherein the weight ratio of polymer:precursor acetate salts in the solution prepared in step 1) preferably ranges between 1.1:2 and 1:2.1, and, more preferably, is approximately 1:2; and
wherein a polyacrylonitrile with a mean molecular weight ranging between 100,000 g/mol and 200,000 g/mol is preferably used, and, more preferably, a PAN with a mean molecular weight of approximately 150,000 g/mol is used.

The following examples of the present invention are offered for illustrative purposes only, and should not be interpreted as limiting the scope thereof.

### Examples

### Starting products and instruments used to prepare the products of the examples

To perform the spray drying process, a commercial atomiser, model Mini Spray Dryer B-290, from the company Buchi, was used.

To perform the drying by electrospinning, a commercial equipment, model NF-103, from the company MECC Co. Ltd., was used.

For the thermal treatment in an inert atmosphere, an oven from the company Carbolite, model CWF 1200, was used, equipped with a gas chamber from Inconel^{®}.

To observe and obtain images of the nanostructures obtained in the examples, a scanning electronic microscope, or SEM, model JSM-6010-LV, from the company JEOL, was used.

To obtain the X-ray diffractograms, or XRD, of the skutterudites obtained, a four-circle diffractometer, model Philips X'Pert, was used.

The following solvents and reagents were used: *N,N*-dimethylformamide (DMF) from the company Sigma-Aldrich, polyacrylonitrile powder (PAN) with a molecular weight of 150,000 and powder polyvinylpyrrolidone (PVP) with a molecular weight of 1,300,000, both from the company Sigma-Aldrich; cobalt (III) acetate tetrahydrate (98% purity) from the company Alfa-Aesar; antimony (III) acetate (97% purity), nickel (II) acetate tetrahydrate (99.999% purity), barium (II) acetate (99% purity), lanthanum (III) acetate (purity greater than 99.99%), ytterbium (III) acetate (99.999% purity), and iron (II) acetate (99.999% purity), all of them from the company Sigma-Aldrich.

### Example 1: Preparation of a nanostructured skutterudite with the formula CoSb₃ according to the method of the invention, by means of spray-drying

11.07 g of PVP were dissolved in 50 g of DMF in a container. In a second container, a solution was prepared with the precursor acetate salts, i.e. antimony (III) acetate and cobalt (II) acetate at a 3:1 molar ratio, to which end 8.6634 g of antimony (III) acetate (Sb(CH₃COO)₃) were dissolved in 50 g of DMF, and, subsequently, 2.4066 g of cobalt (II) acetate tetrahydrate (Co(CH₃COO)₂-4H₂0) were slowly added, keeping the container in an ultrasonic bath for 1 hour, after which time a pink-coloured solution was obtained.

Both solutions were mixed under vigorous mechanical stirring using a Dispermat® CV3 stirrer and further adding 15 g of DMF. The resulting solution was left under magnetic stirring overnight.

Subsequently, the solution was subjected to a spray drying process, at a temperature of 170ºC and a flow rate of 6 ml/min. A pink-coloured fibrous solid consisting of microparticles and nanofibres (15 g) was obtained.

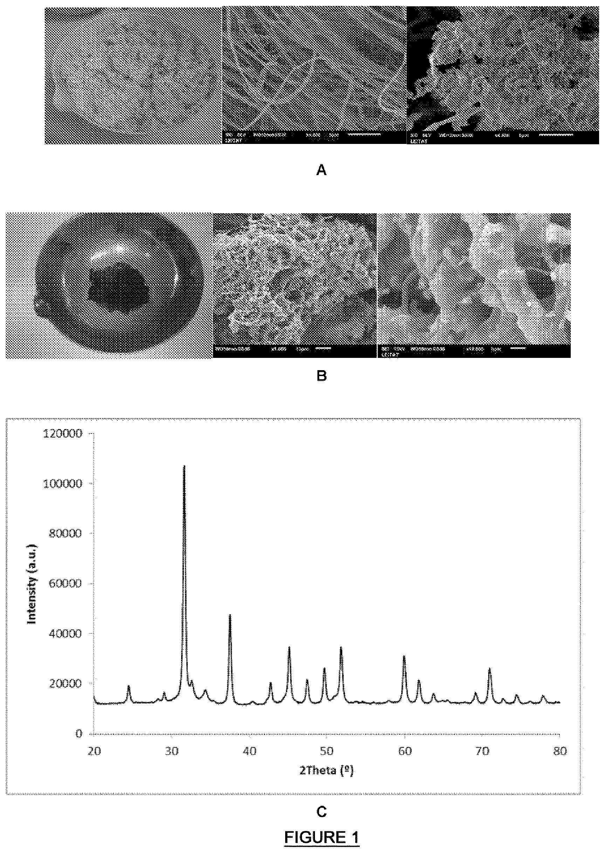

Figure 1-A shows a photograph of the solid obtained (photograph on the left) and two images (photographs at the centre and on the right) obtained with the scanning electronic microscope, where the nanostructuring of this intermediate may be observed.

10 g of this solid were thermally treated in an oven, in an argon atmosphere at a temperature of 550ºC for 6 h, at a heating rate of 10ºC/min, after which 4 g of CoSb₃ skutterudite were obtained (40% yield).

Figure 1-B shows a photograph of the skutterudite obtained (photograph on the left) and two images (photographs at the centre and on the right) obtained with the scanning electronic microscope, where the nanostructure of the skutterudite may be observed.

Figure 1-C shows the X-ray diffractogram of the skutterudite with the formula CoSb₃ obtained in this example, which presents a high degree of purity and is characterised in that it comprises peaks at the following angles 2Theta: 31.64; 37.56; 45.18; 47.48; 49.74; 51.84; 59.92; 61.82; 69.14 and 70.95 ± 0.02.

### Example 2: Preparation of the nanostructured doped skutterudite with the formula Ni_{0.15}Co_{0.85}Sb₃ according to the method of the invention, by means of spray-drying

In order to prepare the skutterudite of the CoSb₃ type doped with nickel (x = 0.15), a method analogous to that of Example 1 was followed, but adding the nickel acetate salt as the third precursor.

Thus, 44.28 g of PVP were dissolved in 200 g of DMF in a container. In a second container, a solution was prepared with the precursor acetate salts, i.e. antimony (III) acetate, cobalt (II) acetate and nickel (II) acetate according to a stoichiometric ratio between Sb:Co:Ni, i.e. 3:0.85:0.15, to which end 34.6548 g of antimony (III) acetate (Sb(CH₃COO)₃) were dissolved in 200 g of DMF, and, subsequently, 8.1825 g of cobalt (II) acetate tetrahydrate (Co(CH₃COO)₂-4H₂0) and 1.4426 g of nickel acetate tetrahydrate (Ni(CH₃COO)₂-4H₂0) were slowly added, keeping the container in an ultrasonic bath for 1 hour. Both solutions were mixed under vigorous mechanical stirring using a Dispermat® CV3 stirrer and further adding 15 g of DMF. The resulting solution was left under magnetic stirring overnight.

Said solution was subjected to the spray drying process at a temperature of 170ºC and a flow rate of 6 ml/min. The intermediate solid product obtained was thermally treated in an argon atmosphere at a heating rate of 10°C/min and a temperature of 550ºC for 6 hours.

Approximately 25 g of doped skutterudite with the formula Ni_{0.15}Co_{0.85}Sb₃ were obtained from 72 g of the atomised intermediate (35% yield).

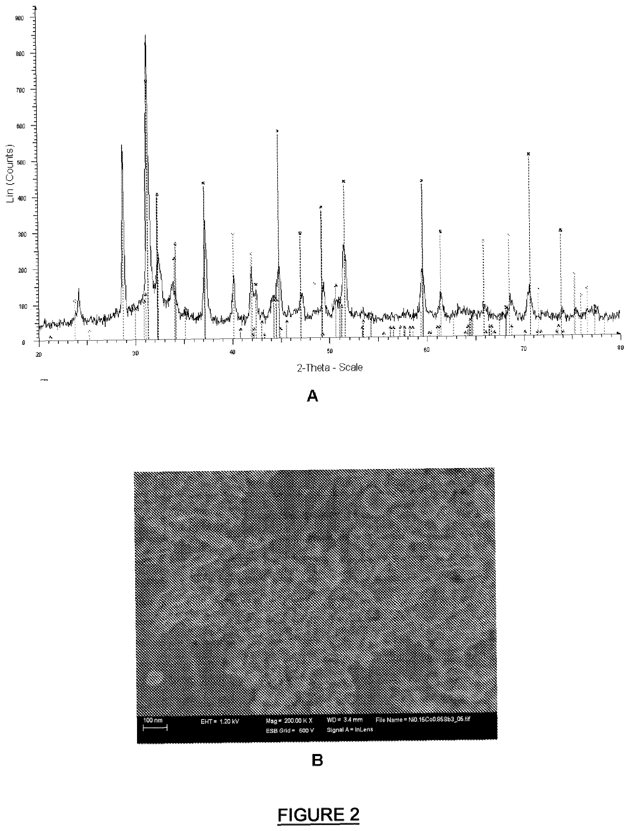

Figure 2-A shows the X-ray diffraction pattern of the doped skutterudite obtained.

Figure 2-B shows an image obtained with the scanning electronic microscope, SEM, where the nanostructuring of the doped skutterudite obtained may be observed.

### Example 3: Preparation of the nanostructured doped skutterudite with the formula Fe_{0.2}Co_{0.8}Sb₃ according to the method of the invention, by means of spray-drying

A skutterudite of the type CoSb₃, doped with iron (*x* = 0.2), with the formula Fe_{0.2}Co_{0.8}Sb₃ was prepared, to which end the precursor acetate salts were used, according to a stoichiometric molar ratio between Sb:Co:Fe, i.e. 3:0.8:0.2.

To this end, the same method described in Example 2 was followed, using the following starting products: 44.28 g of PVP, 35.11404 g of Sb(CH₃COO)₃, 7.8030 g of Co(CH₃COO)₂-4H₂0 and 1.362 g of Fe(CH₃COO)₂, and a total of 460 mg of DMF, as in the preceding example.

Following a method analogous to that of Example 2, under the same conditions for the atomisation process and the thermal treatment, the doped skutterudite of the title, Fe_{0.2}Co_{0.8}Sb₃, was finally obtained. Approximately 17 g of this compound were obtained from 50 g of precursors (34% yield).

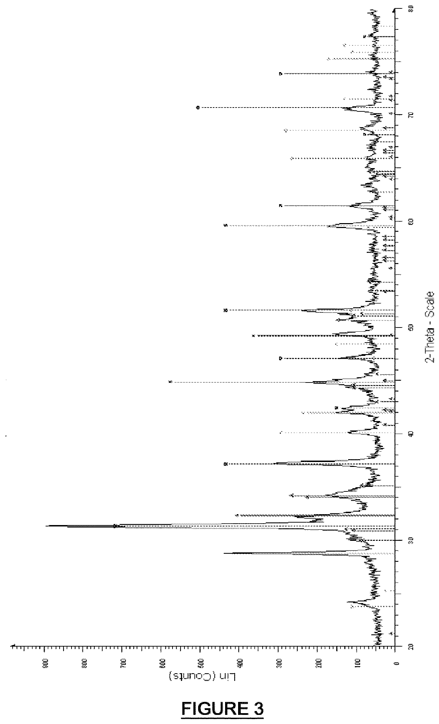

Figure 3 shows the X-ray diffraction pattern of the doped skutterudite obtained.

### Examples 4 and 5: Preparation of the nanostructured filled skutterudites (rattled) with the formulas Yb_{0.002}Ba_{0.08}La_{0.05}CO₄Sb₁₂ and Ba_{0.3}Ni_{0.05}C0_{3.95}Sb₁₂ according to the method of the invention, by means of spray-drying

Following a method analogous to that used in Examples 2 and 3, two filled skutterudites were prepared, specifically, with the formulas Yb_{0.002}Ba_{0.08}La_{0.05}Co₄Sb₁₂ (filled with Yb, Ba and La, *y* = 0.002 + 0.08 + 0.05 = 0.132) and Ba_{0.3}Ni_{0.05}Co_{3.95}Sb₁₂ (filled with Ba, *y* = 0.3, and doped with Ni, *x'* = 0.05). The starting products listed in the following table were used:

| | **Example 4** Yb_{0.002}Ba_{0.08}La_{0.05}Co₄Sb₁₂ | **Example 5** Ba_{0.3}Ni_{0.05}Co_{3.95}Sb₁₂ |
|---|---|---|
| Polymer (PVP) | 44.28 g | 44.28 g |
| Precursor acetate salts | 34.3763 g Sb(CH₃COO)₃ | 34.084 g Sb(CH₃COO)₃ |
| | 9.5512 g Co(CH₃COO)₂-4H₂0 | 9.3496 g Co(CH₃COO)₂-4H₂0 |
| | 0.0067 g Yb(CH₃COO)₃ | |
| | 0.1514 g La(CH₃COO)₃ | 0.1182 g Ni(CH₃COO)₃-4H₂0 |
| | 0.1958 g Ba(CH₃COO)₂ | 0.7279 g Ba(CH₃COO)₂ |
| Solvent (DMF) | 460 g | 460 g |

In both cases, an analogous method was followed: preparing a solution with the polymer in 200 g of DMF and another solution with the precursor acetate salts in 200 g of DMF, in this case by first dissolving the antimony salt and adding the others gradually, and finally mixing both solutions, under vigorus stirring and adding 60 additonal g of DMF. After leaving the mixture under magnetic stirring overnight, it was subjected to atomisation (T = 170ºC, flow rate = 6 ml/min).

The atomised material obtained was thermally treated in an argon atmosphere, at a heating rate of 10ºC/min and a temperature of 550ºC for 6 h.

The following were obtained: respectively, 19 g of the filled skutterudite (rattled) with the formula Yb_{0.002}Ba_{0.08}La_{0.05}Co₄Sb₁₂ from 55 g of precursors (35% yield) and 18 g of the filled doped skutterudite with the formula Ba_{0.3}Ni_{0.05}Co_{3.95}Sb₁₂ from 50 g of precursors (36% yield).

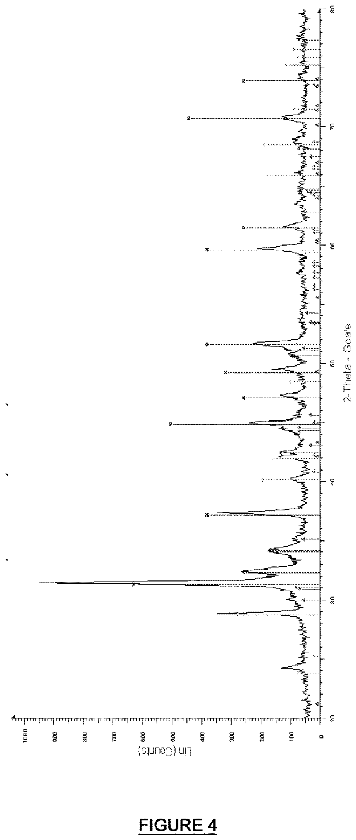

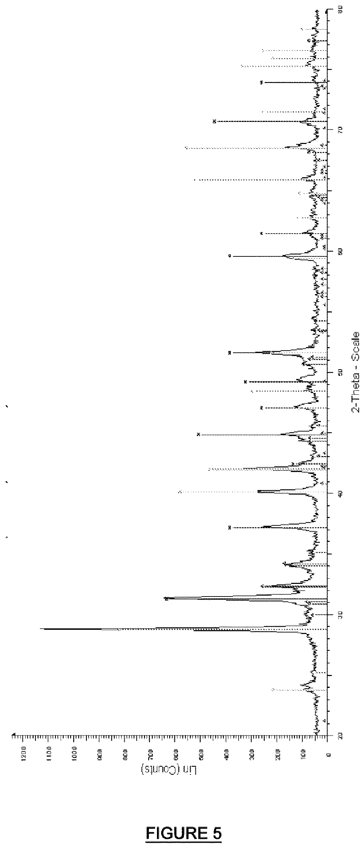

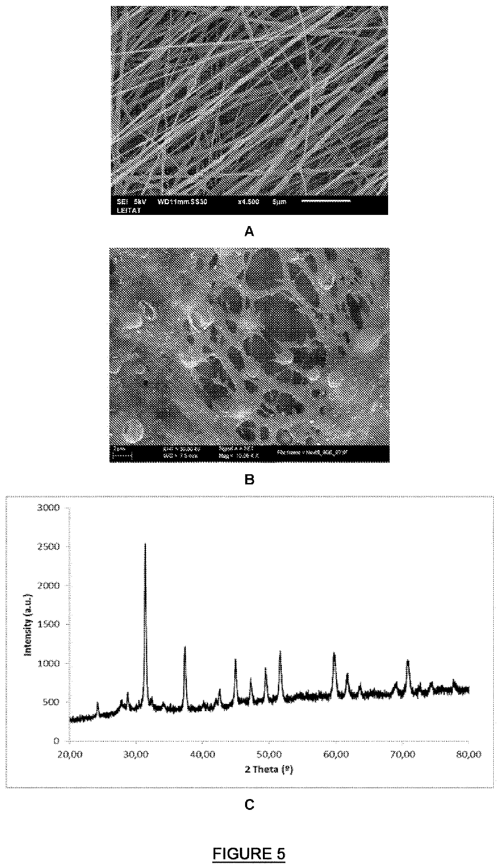

Figure 4 and Figure 5 show, respectively, the X-ray diffractogram of the Yb_{0.002}Ba_{0.08}La_{0.05}Co₄Sb₁₂ skutterudite and the Ba_{0.3}Ni_{0.05}Co_{3.95}Sb₁₂ skutterudite, where the CoSb₃ phase is confirmed.

### Example 6: Preparation of a nanostructured skutterudite with the formula CoSb₃ according to the method of the invention, using PVP as the polymer and drying by electrospinning

16.9394 g of PVP were dissolved in 47 g of DMF in a container. In a second container, a solution was prepared with the precursor acetate salts, i.e. antimony (III) acetate and cobalt (II) acetate, at a 4.5:1 molar ratio, to which end 14.2926 g of Sb(CH₃COO)₃ were dissolved in 47 g of DMF, and, subsequently, 2.6468 g of Co(CH₃COO)₂-4H₂0 were slowly added, keeping the container in an ultrasonic bath for 1 hour, after which period a pink-coloured solution was obtained.

Both solutions were mixed under vigorous mechanical stirring using a Dispermat^{®} CV3 stirrer, and further adding 10 g of DMF. The resulting solution was left under magnetic stirring overnight.

Subsequently, the solution was subjected to an electrospinning process under the following conditions: voltage = 30 kV, flow rate = 1-3 ml/h (1 needle) or 7 ml/h (multijet), needle-collector distance = 5 cm, collection rate = 500 rpm. Pink-coloured nanofibres were obtained, forming a mesh.

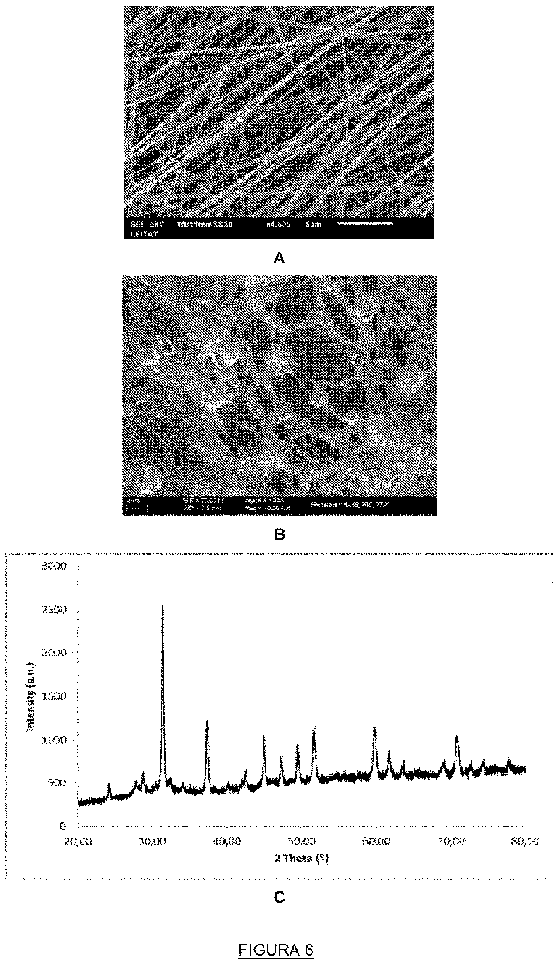

Figure 6-A shows an image of the nanofibres resulting from the electrospinning process, obtained with the scanning electronic microscope.

This product resulting from the electrospinning process was subjected to a thermal treatment in an argon atmosphere, using a heating rate of 10ºC/min, at a temperature of 800ºC for 3h, after which period the skutterudite with the formula CoSb₃ was obtained.

Figure 6-B corresponds to an image obtained with the scanning electronic microscope, which shows the skutterudite obtained after the thermal treatment.

Figure 6-C shows the X-ray diffractogram of the skutterudite with the formula CoSb₃ obtained in this example, which presents a high degree of purity and a profile analogous to that of the product obtained in Example 1, with peaks at the following angles 2Theta: 31.40; 37.36; 44.98; 47.25; 49.49; 51.70; 59.77; 61.74 and 70.79 ± 0.02.

### Example 7: Preparation of a nanostructured skutterudite with the formula CoSb₃ according to the method of the invention, using PAN as the polymer and drying by electrospinning

The method used was analogous to that described in Example 6, but in this case the polymer used was polyacrylonitrile (PAN) instead of polyvinylpyrrolidone (PVP).

In this case, 5.63 g of PAN, 8.92 g of Sb(CH₃COO)₃, 1.65 g of Co(CH₃COO)₂-4H₂0 and 29.4 g of DMF were used. The molar ratio between the cobalt salt and the antimony salt was, as in the preceding example, 1:4.5. In an analogous manner to that of the preceding examples, the polymer was dissolved separately in 29.4 g of DMF, and the precursor acetate salts were dissolved, also separately, in 29.4 g of DMF, and both solutions were subsequently mixed.

The solution obtained was kept under stirring overnight, and subjected to an electrospinning process under the same conditions as in Example 7.

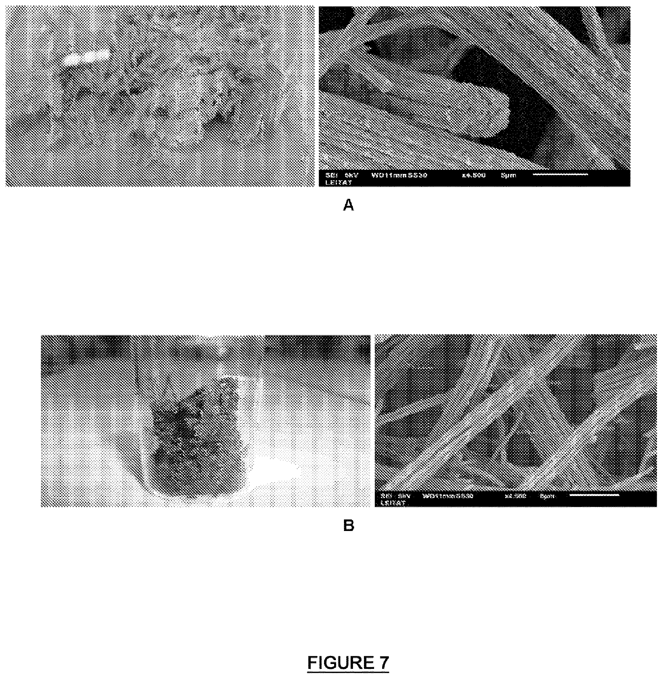

Figure 7-A shows a photograph of the product obtained following the electrospinning process (image on the left) and an image of said product obtained with the scanning electronic microscope, where the nanofibre structure may be observed (image on the right).

This product resulting from the electrospinning process was subjected to a thermal treatment in an argon atmosphere, using a heating rate of 10ºC/min, at a temperature of 550ºC for 16h, after which period the skutterudite with the formula CoSb₃ of the title was obtained. The product obtained presented an X-ray diffractogram substantially analogous to that of the product obtained in Example 1.

Figure 7-B shows a photograph of the skutterudite obtained (image on the left) and an image of said skutterudite obtained with the electronic microscope (image on the right).

## Claims

1. Method for the production skutterudites of the CoSb₃ type, selected from the compound with the general formula (I):
Co₁₋ₓDₓSb₃ (I)
wherein:
D is Ni or Fe, and
*x* ranges between 0 and 0.4,
and the compound with the general formula (II):
R_{y}Co₄-_{x'}D_{x'}Sb₁₂ (II)
wherein:
D is Ni or Fe,
*x'* ranges between 0 and 1.6,
*y* is greater than 0 and less than or equal to 0.75, and
R represents one, two, three or four different elements selected from the group consisting of La, Ce, Yb, Nd, Eu, Pr, Sm, TI, In and Ba,
**characterised in that** it comprises the following steps:
1) dissolving the acetate salts of each of their component elements and a polymer, selected from polyvinylpyrrolidone and polyacrylonitrile, in dimethylformamide;
2) eliminating the dimethylformamide from the solution prepared in step 1) by means of atomisation or electrospinning; and
3) thermally treating the product obtained in step 2) at a temperature ranging between 500ºC and 850ºC in an inert gas atmosphere.

2. Method according to claim 1, wherein *x* ranges between 0 and 0.25; *x'* ranges between 0 and 1; and *y* is greater than 0 and less than or equal to 0.5.

3. Method according to claims 1 or 2, wherein y is greater than 0 and less than or equal to 0.3.

4. Method according to any of claims 1 to 3, wherein, for the skutterudites with the general formula (II), R is selected from the group consisting of La, Ce, Yb and Ba.

5. Method according to any of claims 1 to 4, wherein step 2) is performed by atomisation.

6. Method according to claim 5, wherein the concentration of the polymer in the solution prepared in step 1) ranges between 5% and 10% by weight.

7. Method according to claims 5 or 6, wherein the polymer is polyvinylpyrrolidone.

8. Method according to any of claims 5 to 7, wherein the concentration of the precursor acetate salts in the solution prepared in step 1) ranges between 5% and 10% by weight.

9. Method according to any of claims 5 to 8, wherein the weight ratio of polymer:precursor acetate salts in the solution prepared in step 1) ranges between 1.1:1 and 1:1.1.

10. Method according to any of claims 5 to 9, wherein the proportion between the precursor acetate salts used to prepare the solution of step 1) is a stoichiometric molar ratio.

11. Method according to any of claims 5 to 10, wherein the thermal treatment of step 3) is preferably performed at a temperature ranging between 500ºC and 650ºC.

12. Method according to any of claims 1 to 4, wherein step 2) is performed by electrospinning.

13. Method according to claim 12, wherein polyvinylpyrrolidone is used in step 1).

14. Method according to claim 13, wherein the concentration of polyvinylpyrrolidone in the solution prepared in step 1) ranges between 8% and 14%, expressed by weight.

15. Method according to claim 14, wherein the weight ratio of polyvinylpyrrolidone:precursor acetate salts in the solution of step 1) ranges between 1.1:1 and 1:1.1.

16. Method according to claim 12, wherein polyacrylonitrile is used in step 1).

17. Method according to claim 16, wherein the concentration of polyacrylonitrile in the solution prepared in step 1) ranges between 4% and 8%, expressed by weight.

18. Method according to claim 17, wherein the weight ratio of polyacrylonitrile:precursor acetate salts in the solution of step 1) ranges between 1:2.1 and 1.1:2.

19. Method according to claim 1 for preparing a skutterudite with the formula CoSb₃, comprising the following steps:
1) dissolving cobalt (II) acetate and antimony (III) acetate, according to a 1:3 molar ratio, and polyvinylpyrrolidone in dimethylformamide, wherein the concentration of polyvinylpyrrolidone ranges between 5% and 10%, and the concentration of the acetate salts ranges between 5% and 10%, wherein the percentages are expressed by weight;
2) eliminating the dimethylformamide from the solution prepared in step 1) by means of atomisation; and
3) thermally treating the product obtained in step 2) at a temperature ranging between 500ºC and 650ºC in an inert gas atmosphere for a period ranging between 5 and 7 hours.

20. Method according to any of claims 1 to 2 for preparing a skutterudite with the formula (I), comprising the following steps:
1) dissolving cobalt (II) acetate, antimony (III) acetate and a salt selected from iron (II) acetate and nickel (II) acetate, according to a (1 - x):3:x molar ratio, and polyvinylpyrrolidone in dimethylformamide, wherein the concentration of polyvinylpyrrolidone ranges between 5% and 10%, and the concentration of the acetate salts ranges between 5% and 10%, and wherein the percentages are expressed by weight;
2) eliminating the dimethylformamide from the solution prepared in step 1) by means of atomisation; and
3) thermally treating the product obtained in step 2) at a temperature ranging between 500ºC and 650ºC in an inert gas atmosphere for a period ranging between 5 and 7 hours.

21. Method according to claim 1 for preparing a skutterudite with the formula (II), comprising the following steps:
1) dissolving cobalt (II) acetate, antimony (III) acetate, optionally a salt selected from iron (II) acetate and nickel (II) acetate, and the acetate salt(s) of the filler element(s) R, according to a (4 - x):12:*x':y* molar ratio, and polyvinylpyrrolidone in dimethylformamide, wherein the concentration of polyvinylpyrrolidone ranges between 5% and 10%, and the concentration of the precursor acetate salts ranges between 5% and 10%, and wherein the percentages are expressed by weight;
2) eliminating the dimethylformamide from the solution prepared in step 1) by means of atomisation; and
3) thermally treating the product obtained in step 2) at a temperature ranging between 500ºC and 650ºC, in an inert gas atmosphere for a period ranging between 5 and 7 hours.

22. Method according to claim 1 for preparing a skutterudite with the formula CoSb₃, comprising the following steps:
1) dissolving cobalt (II) acetate and antimony (III) acetate, according to a molar ratio ranging between 1:4.25 and 1:4.75, and polyvinylpyrrolidone in dimethylformamide, wherein the concentration of polyvinylpyrrolidone ranges between 8% and 15%, and the concentration of the precursor acetate salts ranges between 8% and 15%, and wherein the percentages are expressed by weight;
2) eliminating the dimethylformamide from the solution prepared in step 1) by means of electrospinning; and
3) thermally treating the product obtained in step 2) at a temperature ranging between 700ºC and 850ºC in an inert gas atmosphere for a period ranging between 2 and 4 hours.

23. Method according to claim 1 for preparing a skutterudite with the formula CoSb₃, comprising the following steps:
1) dissolving cobalt (II) acetate and antimony (III) acetate, according to a molar ratio ranging between 1:4.25 and 1:4.75, and polyacrylonitrile in dimethylformamide, wherein the concentration of polyacrylonitrile ranges between 4% and 10%, and the concentration of the precursor acetate salts ranges between 8% and 20%, and wherein the percentages are expressed by weight;
2) eliminating the dimethylformamide from the solution prepared in step 1) by means of electrospinning; and
3) thermally treating the product obtained in step 2) at a temperature ranging between 500ºC and 600ºC in an inert gas atmosphere for a period ranging between 10 and 18 hours.
